Europäisches Patentamt

European Patent Office

Office européen des brevets

(19)

(11) Numéro de publication : **0 259 414 B1**

# (12) FASCICULE DE BREVET EUROPEEN

(45) Date de publication du fascicule du brevet :
06.03.91 Bulletin 91/10

(21) Numéro de dépôt : 87901501.4

(22) Date de dépôt : 18.02.87

(86) Numéro de dépôt international :
PCT/FR87/00043

(87) Numéro de publication internationale :
WO 87/05054 27.08.87 Gazette 87/19

(51) Int. Cl.⁵ : **C23C 16/48, C30B 33/00, F27B 17/00, C21D 1/34, H01L 21/00, H05B 3/00**

(54) APPAREIL POUR TRAITEMENTS THERMIQUES DE PIECES MINCES, TELLES QUE DES PLAQUETTES DE SILICIUM.

(30) Priorité : 19.02.86 FR 8602239

(43) Date de publication de la demande :
16.03.88 Bulletin 88/11

(45) Mention de la délivrance du brevet :
06.03.91 Bulletin 91/10

(84) Etats contractants désignés :
AT BE CH DE FR GB IT LI LU NL SE

(56) Documents cités :
DE-A- 3 163 105
FR-A- 2 207 757
GB-A- 2 065 973
GB-A- 2 083 728
US-A- 3 627 590

(56) Documents cités :
Applied Physics Letters, volume 36, January 1980, American Institute of Physics, (New York, US), Juh Tzeng Lue : "Arc annealing of BF+2 implanted silicon by a short pulse flash lamp", pages 73-76
Patent Abstracts of Japan, volume 1, no. 106, 19 September 1977, page 2503C77

(73) Titulaire : BERTIN & CIE SOCIETE ANONYME
B.P.3, Zone Industrielle
F-78373 PlaisirCédex (FR)

(72) Inventeur : JANNOT,Marcel Augustin Joseph
3, rue des Sources
F-95200 Sarcelles (FR)
Inventeur : PATUREAU, Jean-Pierre
4, rue Fernand Quéré
F-78160 Marly-Le-Roi (FR)

(74) Mandataire : Orès, Bernard et al
Cabinet ORES 6, Avenue de Messine
F-75008 Paris (FR)

## Description

La présente invention est relative à un appareil pour traitements thermiques de pièces minces, telles que des plaquettes de silicium, notoirement appelées "wafers" selon la terminologie anglo-saxonne, et utilisées dans le domaine de la micro-électronique.

Dans ce type de traitements, on utilise souvent comme source thermique des sources lumineuses, et ce en raison de l'inertie thermique quasi-inexistante de ce type de sources qui permettent ainsi un contrôle optimum du cycle thermique, par exemple, en maîtrisant mieux certains aspects des échanges thermiques solide/solide.

Il s'agit de sources lumineuses de très forte puissance, et ce en raison des niveaux et des temps de montée en température qu'il est souhaitable d'atteindre dans ce type de traitements thermiques.

Or, la nécessité d'obtenir des températures uniformément distribuées dans les pièces à traiter – ce qui s'impose pour limiter les contraintes thermomécaniques et les défauts qui en découleraient dans ces pièces – pose des problèmes très délicats de mise en oeuvre.

Un moyen utilisé à cet effet consiste à générer un faisceau de rayons lumineux parallèles à l'aide d'un miroir, par exemple parabolique, ayant la taille de la pièce à traiter. Cela implique l'utilisation d'une source lumineuse ponctuelle disposée au foyer du miroir, à savoir d'une lampe à arc dont le coût très élevé, la mise en oeuvre difficile et la faible durée de vie limitent considérablement les applications industrielles.

Il existe aussi des appareils de traitements thermiques utilisant des sources lumineuses linéaires, dont le coût et la facilité d'exploitation sont sans commune mesure plus intéressants que dans le cas des lampes à arc : il s'agit, notoirement, des lampes dites "tungstène-halogène" (à savoir, de lampes à incandescence à filament de tungstène et aux halogènes, ces derniers étant utilisés pour diminuer le noircissement de l'ampoule ou du tube qui contient le filament, (cf. en particulier la revue SEMICONDUCTOR INTERNATIONAL/79, n° de mai 1985).

Toutefois, dans ce type d'appareils, l'uniformité des températures est obtenue en disposant les lampes "tungstène-halogène" au voisinage de ces pièces, ce qui limite les traitements thermiques qu'on peut effectuer sur ces dernières à des traitements à la pression ambiante, comme le recuit par exemple.

On connaît, par le document FR-A-2 207 757, un appareil de chauffage de pièces minces comprenant un réacteur étanche contenant des substrats mono-cristallins et placé lui-même dans une enceinte étanche comportant une source lumineuse de chauffage, les parois internes de cette enceinte étant réfléchissantes pour limiter les pertes de chaleur et les gradients thermiques des substrats mono-cristallins.

La présente invention a pour but de pourvoir à un appareil pour traitements thermiques de pièces minces, telles que des plaquettes de silicium, du type utilisant comme source thermique les lampes linéaires de très forte puissance, telles que des lampes "tungstène-halogène", qui répond mieux aux nécessités de la pratique que les appareils visant au même but, antérieurement connus, notamment en ce qu'on peut effectuer des traitements thermiques autres que le recuit à la pression ambiante et, d'une façon générale, tout traitement nécessitant la création de conditions ambiantes particulières autour des pièces à traiter, par exemple sous pression ou sous vide, tout en assurant la nécessaire uniformité des températures des pièces.

La présente invention propose donc un appareil pour le traitement thermique d'une pièce mince telle qu'une plaquette circulaire (wafer) de silicium, comprenant une source thermique lumineuse comportant des lampes linéaires de très forte puissance unitaire telles que des lampes "tungstène-halogène", une enceinte à section circulaire dont l'axe de symétrie géométrique coïncide avec l'axe de symétrie optique de la source thermique lumineuse, cette enceinte délimitant une chambre étanche contenant la pièce à traiter et permettant de créer autour de celle-ci des conditions particulières de traitement thermique notamment sous pression ou sous vide ou dans une atmosphère d'un gaz approprié, et un moyen de compensation des pertes thermiques de la pièce à traiter, permettant de maintenir sensiblement uniforme sa température, caractérisée en ce que le moyen de compensation des pertes thermiques de la pièce à traiter est constitué par un réflecteur annulaire placé dans la chambre précité et entourant étroitement la pièce à traiter, le diamètre interne et la hauteur de ce réflecteur annulaire étant choisis de telle sorte qu'il n'y ait pas occultation partielle de la source lumineuse.

Selon un mode de réalisation de l'invention, le réflecteur de compensation thermique est constitué par une pièce toroïdale massive, dont la face interne est dorée et qui est fixée à la paroi interne de l'enceinte par tous moyens appropriés, notamment par vissage, de manière à assurer un contact intime entre la paroi interne de l'enceinte et la face externe de la pièce toroïdale massive.

Selon une modalité avantageuse de cette disposition, une gorge toroïdale coaxiale est ménagée à la périphérie de la paroi de la pièce toroïdale massive, laquelle gorge communique avec des orifices distributeurs radiaux permettant l'introduction dans la chambre de traitement d'au moins un gaz approprié créant une atmosphère contrôlée.

Selon un autre mode de réalisation, ledit réflecteur de compensation thermique est constitué par un clinquant qui est doré sur sa face interne et dont la configuration annulaire est obtenue par roulage et est maintenue par serrage à l'aide d'une bague inoxydable d'épaisseur appropriée.

Selon une autre disposition avantageuse de ce mode de réalisation, la pièce à traiter est maintenue par des moyens de support et de centrage par rapport au réflecteur de compensation thermique.

Selon une modalité avantageuse de cette disposition, le moyen de support et de centrage est constitué par trois plots à calotte sphérique encastrés dans le fond de l'enceinte et permettant de réduire au minimum le contact avec la pièce à traiter et donc d'influencer le moins possible les échanges thermiques de celle-ci, chaque plot coopérant avec un moyen de butée latérale de centrage faisant saillie vers le haut à partir de la paroi latérale externe du plot.

Selon un mode de réalisation avantageux de l'appareil conforme à l'invention, la chambre de traitement comporte un moyen d'accès et est délimitée par la paroi latérale et le fond de l'enceinte ainsi que par un hublot cylindrique, réalisé en silice et entièrement poli, ayant un diamètre et une épaisseur appropriés et interposé entre la source et la pièce à traiter et dont l'axe coïncide avec l'axe optique de la source et l'axe de l'enceinte, la paroi latérale de l'enceinte comportant un siège sur lequel prend appui le hublot, ce dernier étant maintenu en position par l'intermédiaire d'une bride de fixation qui serre le hublot contre son siège à l'aide d'une pluralité de vis réalisées en un matériau ayant un coefficient de dilatation thermique pratiquement négligeable, entre ledit siège et le hublot et ce dernier et la bride de fixation étant disposé, respectivement, un joint d'étanchéité en matériau approprié, tel que du graphite expansé.

Selon une disposition préférée de ce mode de réalisation, ledit moyen d'accès à la chambre de traitement est constitué par le fond lui-même, lequel fond coopère avec des moyens d'ouverture et de fermeture rapides, autorisant ainsi une augmentation des cadences de fonctionnement et constitués par le plateau mobile d'une presse duquel est solidaire le fond de l'enceinte, le plateau fixe ou sommier de presse étant solidarisé avec la partie supérieure de l'enceinte par l'intermédiaire de colonnettes rigides, l'étanchéité à l'interface enceinte/fond étant assurée par la coopération des moyens suivants :

– une nervure annulaire faisant saillie de l'une ou l'autre des surfaces de séparation enceinte/fond et à laquelle se transmet, par l'intermédiaire desdites colonnettes, l'effort de pressage,
– une cavité toroïdale disposée à l'extérieur de ladite nervure annulaire et destinée à la récupération des fuites de gaz éventuelles, à cet effet la cavité étant reliée à un circuit de récupération en dépression,
– un joint en un matériau approprié, tel que du graphite expansé, disposé à l'extérieur de cette cavité toroïdale.

Selon une disposition avantageuse de ce mode de réalisation, ledit moyen d'accès à la chambre de traitement est constitué par le fond même de ladite enceinte, lequel fond est amovible et fixé à la base de l'enceinte à l'aide de moyens de fixation détachable.

Selon une modalité avantageuse de cette disposition, les moyens de fixation détachable du fond à la base de l'enceinte sont constitués par une pluralité de vis réalisées en un matériau ayant un coefficient de dilatation thermique pratiquement négligeable, un joint d'étanchéité en matériau approprié, tel que du graphite expansé, étant disposé entre ledit fond et ladite enceinte.

Selon un mode de réalisation préférée de l'appareil conforme à l'invention, ladite source thermique lumineuse est réalisée sous la forme d'une boîte à lumière ayant une structure modulaire qui permet d'adapter la puissance installée à la puissance requise par le traitement de la pièce et comportant :

– au moins un module creux à section polygonale, délimité par des parois métalliques latérales verticales, et contenant des rangées horizontales parallèles de lampes linéaires "tungstène-halogène" qui traversent deux parois adjacentes du module, de manière que les culots des lampes se trouvent disposés à l'extérieur du module et que leur refroidissement, notamment par ventilation forcée, soit efficace, deux lampes consécutives de chaque rangée étant séparées d'un pas approprié permettant le passage entre elles d'une lampe appartenant à chacune des deux rangées de lampes adjacentes, la largeur de chaque paroi étant définie par la dimension utile de chaque lampe, à savoir par la longueur du filament de tungstène,
– un élément métallique de fermeture de l'ouverture supérieure dudit module ou du module situé le plus haut parmi une pluralité de modules du même type superposés l'un à l'autre et dont le nombre est fonction de la puissance requise par le traitement thermique, lequel élément constitue le couvercle ou le plafond de la boîte à lumière,

les faces internes des parois latérales et du plafond de la boîte à lumière étant réfléchissantes dans tout le spectre d'émission des lampes et chaque module étant refroidi par circulation d'un fluide approprié, notamment d'eau.

Selon une disposition avantageuse de ce mode de réalisation, également le plafond de la boîte à lumière coopère avec une rangée de lampes linéaires "tungstène-halogène" disposées horizontalement et parallèlement audit plafond.

Selon une autre disposition avantageuse de ce mode de réalisation, une bride de raccordement relie le module inférieur de la boîte à lumière à l'enceinte, permettant ainsi le passage de la section polygonale du module à la section circulaire de l'enceinte, la paroi interne de la bride de raccordement étant elle aussi réfléchissante dans tout le spectre d'émission des lampes.

Selon un autre mode de réalisation avantageux de l'appareil conforme à l'invention, ladite source est constituée par plusieurs rangées parallèles de lampes "tungstène-halogène", deux lampes consécutives de chaque rangée étant séparées d'un pas approprié et les rangées étant décalées d'un demi-pas et étant disposées à une distance appropriée l'une par rapport à l'autre, la source lumineuse ainsi constituée étant logée dans un capotage en tôle, auquel est fixée ladite enceinte par tous moyens appropriés et qui est refroidi par des ventilateurs, et coopérant avec un réflecteur doré, logé dans ledit capotage, qui est destiné à améliorer son rendement lumineux et est disposé au-dessus et autour de cette source de manière que son axe coïncide avec l'axe optique de cette dernière, ce réflecteur étant refroidi par circulation d'un fluide approprié, notamment d'eau.

Selon un autre mode de réalisation avantageux de l'appareil conforme à l'invention, celui-ci comporte des moyens de réglage de la puissance de chaque module, notamment constitués par des dispositifs de commutation et/ou des dispositifs de variation de la tension d'alimentation des lampes, lesquels moyens de réglage sont commandés par une sonde pyrométrique activée par le rayonnement provenant de la face inférieure de la pièce à traiter, et ce sous le contrôle d'un ordinateur programmé pour compenser toute variation indésirée de la puissance installée ainsi que pour adapter le traitement thermique à un cycle bien déterminé.

Selon une disposition avantageuse de ce mode de réalisation, le rayonnement activant la sonde pyrométrique se propage à travers :

– un premier conduit axial ménagé dans le fond de l'enceinte et s'ouvrant supérieurement dans la chambre de traitement,

– un hublot de visée de la face inférieure de la pièce à traiter, disposé à la suite et à la partie inférieure de ce conduit axial, dont l'axe est aligné avec celui du hublot de visée,

– un prisme logé dans une pièce rapportée, logée à son tour dans le fond de l'enceinte, le rayonnement étant dirigé du hublot de visée vers ce prisme par un deuxième conduit axial ménagé dans ladite pièce rapportée,

– une fibre optique disposée à 90° par rapport à l'axe de la chambre de traitement thermique, le rayonnement étant dirigé du prisme vers la fibre optique par l'intermédiaire d'un conduit transversal perpendiculaire audit deuxième conduit axial et ménagé, comme ce dernier, dans ladite pièce rapportée.

Selon un mode de réalisation avantageux de l'appareil conforme à l'invention, celui-ci comporte des moyens de conditionnement thermique destinés à limiter la montée en température du hublot et constitués par un circuit traversé par un fluide thermostaté approprié, notamment tel que de l'huile issue d'un bain thermostaté, et comportant des chemises de conditionnement ménagées dans l'enceinte, à la périphérie du hublot et autour des vis de serrage de ladite bride de fixation.

Selon un autre mode de réalisation avantageux de l'appareil conforme à l'invention, le fond de l'enceinte comporte des moyens de conditionnement thermique du type utilisé pour l'enceinte, à savoir constitués par un circuit traversé par un fluide thermostaté approprié, tel que de l'huile issue d'un bain thermostaté, et comportant une chemise de conditionnement ménagée dans le fond de l'enceinte.

Outre les dispostions qui précèdent, l'invention comprend encore d'autres dispositions, qui ressortiront de la description qui va suivre.

L'invention sera mieux comprise à l'aide du complément de description qui va suivre qui se réfère aux dessins annexés dans lesquels :

• la figure 1 est une vue schématique en section et avec arrachements partiels montrant un mode non limitatif de réalisation de l'appareil conforme à l'invention ;

• la figure 2 est une vue également en section du réflecteur de compensation thermique selon l'invention, qui a été représenté à une échelle plus grande que celle utilisée dans la figure 1 ;

• la figure 3 est une vue en section d'une variante de réalisation de l'appareil selon l'invention.

Il doit être bien entendu, toutefois, que ces dessins et les parties descriptives correspondantes, sont donnés uniquement à titre d'illustration de l'objet de l'invention, dont ils ne constituent en aucune manière une limitation.

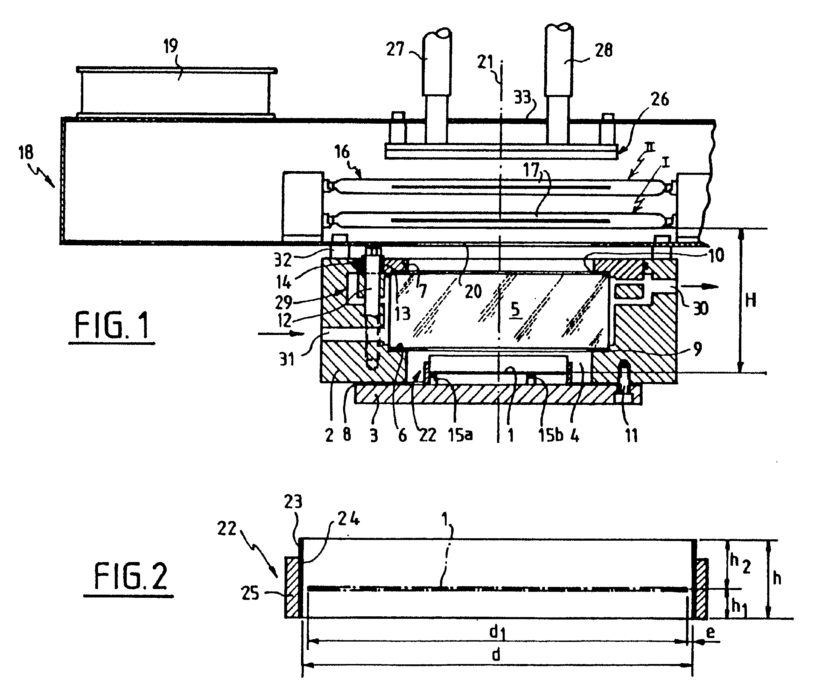

L'appareil illustré à la figure 1 est destiné à permettre la réalisation de traitements thermiques d'une pièce mince 1, telle qu'une plaquette de silicium par exemple, qui est contenue dans une enceinte (ou four proprement dit) 2 qui est constituée d'une enveloppe cylindrique (barillet) en acier inoxydable comportant un moyen d'accès au four qui est constitué par une plaque 3 en acier inoxydable massif fermant la base de l'enceinte et serrée par 16 vis (dont une vis 11 seulement a été représentée pour des raisons de simplification).

La face supérieure de la plaque 3, à savoir la face qui est orientée vers l'intérieur du four 2, est polie et ensuite traitée avec un dépôt or et avec une couche de protection, ce traitement permettant d'obtenir une très bonne réflectivité à partir de 0,7 μm jusqu'à l'infrarouge lointain, à savoir pratiquement dans tout le spectre d'émission des lampes utilisées.

L'étanchéité par rapport à la base de l'enceinte 2 est obtenue à l'aide d'un joint 8 en graphite expansé (par exemple en "CEFILAC", qui est une marque de fabrique).

Conformément à l'invention, dans le barillet 2 est ménagée une chambre 4 délimitée par la paroi latérale et le fond 3 de l'enceinte en coopération avec un hublot cylindrique 5 de silice entièrement poli, dont le diamètre (dans l'exemple de figure) est 160 mm et l'épaisseur 55 mm.

Le hublot prend appui sur un siège annulaire 6 ménagé dans la paroi latérale du four et est maintenu en position par l'intermédiaire d'une bride de serrage 7 : toujours limitativement à l'exemple illustré, l'effort de serrage est obtenu par 16 vis (dont une vis 12 seulement a été représentée, et ce également pour des raisons de simplification).

L'étanchéité du hublot 5 par rapport au siège 6 de l'enceinte 2 et à la bride de fixation 7 est obtenue, respectivement, à l'aide de deux autres joints 9 et 10 en graphite expansé identique au joint 8 utilisé entre la plaque 3 et le barillet 2.

En ce qui concerne les vis de serrage 11 et 12, celles-ci sont réalisées en "invar", à savoir dans un alliage acier/nickel dont le coefficient de dilatation est pratiquement négligeable, et ce pour des raisons de stabilité du serrage lors des variations de température.

Des douilles 13 en cuivre sous les têtes de chaque vis de serrage assurent l'étanchéité et l'adaptation des dilatations.

Un joint "viton" 14 entre la bride de serrage 7 et le barillet 2 complète l'étanchéité.

La pièce à traiter 1 est positionnée et centrée à l'aide des plots 15a, 15b ... à calotte sphérique (de préférence trois plots de ce type sont utilisés), dont la hauteur est de 6 mm dans l'exemple en question.

La chambre de traitement 4 créée dans le barillet 2 permet d'établir autour de la pièce à traiter 1 une ambiance appropriée, par exemple par mise sous pression ou par création de vide ou encore par création d'une atmosphère particulière à l'aide d'un gaz approprié ou autre, tout en permettant l'éclairement et donc l'échauffement de la pièce 1.

Le conditionenment thermique du hublot 5, nécessaire pour limiter sa montée en température, est assuré en particulier par un circuit de conditionnement 29 à circulation d'huile issue d'un bain thermostaté, des chemises de conditionnement étant ménagées à cet effet dans l'enceinte 2, à la périphérie du hublot 5 et autour des vis de serrage 12. Il y a lieu de remarquer que la sortie d'huile 30 est placée en partie haute, alors que l'entrée 31 est placée en partie basse.

La source thermique utilisée dans l'appareil de figure 1 est une source lumineuse 16 comportant des lampes linéaires, à savoir étendues et non ponctuelles, telles que des lampes "tungstène-halogène" 17 ; dans l'exemple non limitatif de la figure 1, on a utilisé 15 lampes de ce type, dont le corps lumineux, à savoir le filament de tungstène, présente une longueur de l'ordre de 160 mm et la puissance lumineuse unitaire est de 1500 watts chacune, lesquelles lampes sont disposées en deux rangées (ou nappes) I et II parallèles, qui sont décalées d'un demi-pas et distantes de 23,5 mm l'une par rapport à l'autre, le pas entre les lampes étant de 16 mm.

L'ensemble des lampes 17 est placé dans un capotage en tôle 18 (auquel est fixée l'enceinte 2, cf. la référence numérique 32 dans la figure 1), qui est refroidi par deux ventilateurs (dont un seul ventilateur 19 est visible dans la figure 1) : le circuit de refroidissement des lampes est conçu de façon à ce que les ventilateurs ne soient pas soumis au rayonnement direct et que l'air frais arrive d'abord au niveau des culots des lampes et ensuite suive les tubes des lampes.

La sortie (non représentée) de l'air se fait latéralement au niveau des lampes protégeant le dessus du barillet 2 et la bride de serrage 7 du flux lumineux. Dans l'exemple représenté, on a réalisé un débit d'air total de l'ordre de 130 litres/seconde. Une ouverture 20 est ménagée dans le capotage 18 en face du hublot 5 et de la pièce à traiter 1, de manière à faire coïncider leurs axes de symétrie avec l'axe optique de la source 16 (cet axe commun est dénoté par la référence 21 dans la figure 1). Or, la présence de la chambre de traitement 4 entre la pièce 1 et la source thermique lumineuse 16, c'est-à-dire l'éloignement de cette source lumineuse de la pièce à traiter, crée des écarts de température importants indésirés entre le centre et la périphérie de la pièce, dont la périphérie est plus froide, donc avec chute de température à la périphérie de la pièce à traiter (comme il a pu être établi par des mesures effectuées sans le moyen de compensation thermique selon l'invention, qui va être décrit ci-après).

Pour compenser les pertes thermiques de la plaquette de silicium par ses faces et sa paroi latérale, à savoir les pertes surfaciques ou axiales et les pertes d'extrémité (de bord) ou radiales, et maintenir ainsi sensiblement uniforme la température de la pièce concernée, on utilise – conformément à l'invention – un moyen de compensation thermique dont la fonction est de corriger la courbe de température de la plaquette de silicium, de manière à obtenir une distribution sensiblement uniforme de la température sur sa surface et au niveau de ses bords, et qui est constitué par un réflecteur annulaire placé dans le volume de confinement entourant la plaquette de silicium.

Dans les figures 1 et 2, ce réflecteur ou correcteur thermique, 22, est constitué par un clinquant 23 qui est doré sur sa face interne 24, dont la configuration annulaire est obtenue par roulage et maintenue par serrage à l'aide d'une bague inoxydable 25 d'épaisseur appropriée.

C'est grâce aux réflexions spéculaires sur la paroi interne 24 du correcteur thermique 22, au fond duquel est placée la pièce à traiter 1, qu'on peut obtenir une bonne uniformité des températures (à savoir, une bonne uniformité du "facteur de vue") entre la source lumineuse étendue et chaque élément de surface de la pièce à traiter, utilisant à cet effet le flux thermique intercepté par sa paroi réfléchissante interne et qui serait autrement perdu. Cela équivaut à dire que le diamètre interne et la hauteur du réflecteur annulaire sont choisis de telle sorte qu'il n'y ait pas occultation partielle de source quel que soit l'élément de surface de la pièce à traiter.

D'une façon générale, plus on s'éloigne de la plaquette à traiter, plus augmente la hauteur $\underline{h}$ du réflecteur de compensation thermique 22, le diamètre interne $\underline{d}$ de celui-ci restant très voisin du diamètre $d_1$ de la plaquette.

Dans l'exemple objet de la présente description, on suppose les conditions géométriques suivantes :
- le réflecteur 22 a une hauteur réfléchissante $\underline{h}$ de 19,5 mm ;
- la surface supérieure de la plaquette de silicium 1 est à une distance $h_1 = 6,5$ mm du fond 3, à savoir à une distance $h_2 = 13$ mm du haut du réflecteur ;
- le diamètre intérieur du réflecteur est de 101,5 mm ;
- le diamètre de la plaquette de silicium est de 100 mm, en sorte qu'il existe un jeu $\underline{e}$ de 0,75 mm entre le réflecteur et la plaquette.

Or, de façon plus précise, l'obtention d'une distribution de températures sensiblement uniformes ("profil" de température uniforme) à la surface de la plaquette de silicium, est liée à la valeur des paramètres $h_2$ et $\underline{e}$ susdits, pour des valeurs préfixées du diamètre $d_1$ de la plaquette, et de la distance H entre la plaquette et la source lumineuse étendue 16, ainsi qu'aux propriétés thermiques (conductibilité thermique notamment) de la pièce à traiter.

En effet, il est possible d'établir des équations mathématiques régissant les échanges thermiques entre la plaquette de silicium et le réflecteur et de vérifier que les paramètres de réglage de base pour l'homogénéité de la température de la pièce à traiter sont constitués par lesdits paramètres $h_2$ et $\underline{e}$, à savoir
– pour une distance $h_1$ donnée (hauteur des plots de support) et pour une plaquette ($d_1$ donnée – par les paramètres $\underline{h}$ ($= h_1 + h_2$) et $\underline{d}$ ($= d_1 + \underline{e}$) du réflecteur conforme à l'invention.

C'est donc en jouant sur ces paramètres qu'on peut s'adapter aux différentes dimensions ($d_1$) des pièces à traiter et aux différentes configurations, à savoir aux différents emplacements (H) de la source lumineuse par rapport à ces pièces.

Avec les valeurs indiquées plus haut pour les paramètres $h_2$, $\underline{e}$ et $d_1$, et en admettant que la source lumineuse soit à une distance H = 75 mm de la plaquette de silicium (wafer), on a pu obtenir une uniformité de température définie par des différences de température de l'ordre de quelques degrés entre deux points quelconques à la surface de la plaquette, et ce pour un niveau de température aussi élevé que 1000°C et même plus, ce qui représente un résultat très satisfaisant et, de toutes façons, plus que suffisant pour que la plaquette ainsi traitée thermiquement présente les qualités requises.

Or, en considération des niveaux de température très élevés, qu'il est souhaitable d'atteindre dans certains types de traitements thermiques, il est bien évident qu'il est nécessaire d'obtenir un bon rendement lumineux.

Dans ce but, on dispose d'un réflecteur doré 26 au-dessus des deux rangées de lampes 17, I et II, qui renvoie la lumière vers le hublot 5 (le réflecteur doré 26 est logé dans le capotage 18 et est fixé à sa paroi supérieure ; de plus, ce réflecteur est refroidi par circulation d'eau, dans la figure 1 étant visibles l'arrivée et la sortie d'eau 27 et 28, respectivement, qui accèdent dans le capotage 18 vers le réflecteur 26 par une ouverture 33 ménagée dans la partie haute du capotage).

Il va de soi qu'il serait préférable de disposer un tel réflecteur doré non seulement au-dessus des lampes, mais aussi autour de celles-ci, bien que cette disposition n'ait pas été représentée pour des raisons de simplification des dessins.

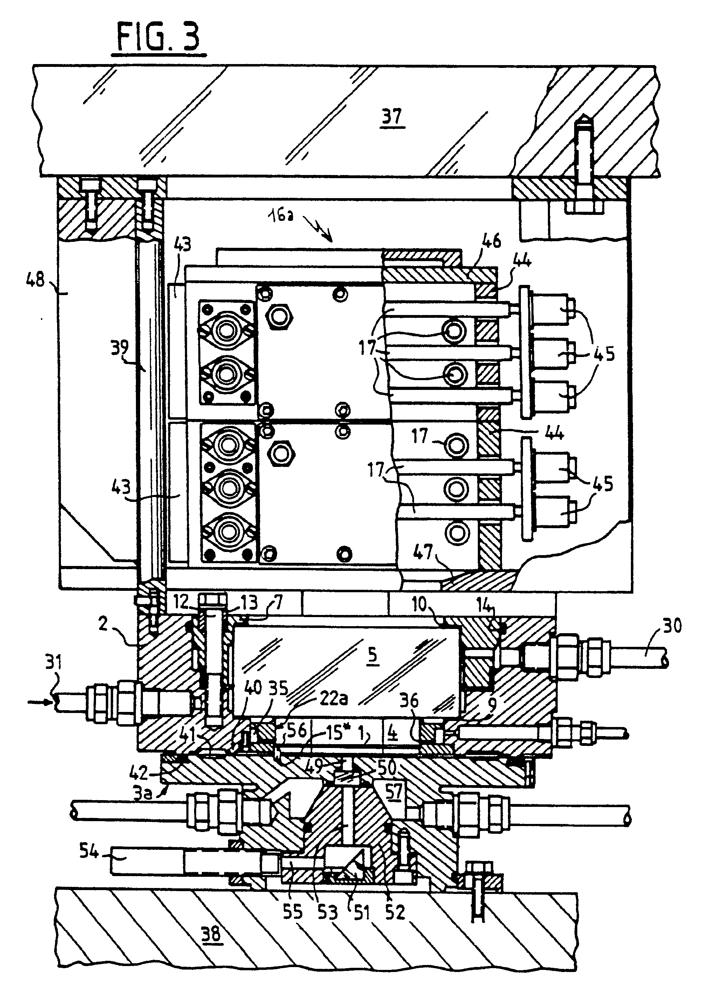

A la figure 3 on a représenté une variante de réalisation de l'appareil représenté à la figure 1.

Les différences principales concernent essentiellement la constitution du réflecteur de compensation thermique (ou correcteur thermique), le fond de fermeture de l'enceinte et la source thermique lumineuse, tandis que les remarques faites en rapport avec la description de la figure 1 relativement à l'enceinte et au hublot, y compris les rapports fonctionnels mutuels entre ces derniers, restent valables.

En ce qui concerne le correcteur thermique représenté à la figure 3 et dénoté par la référence numérique 22a, celui-ci est de constitution massive et est fixé à la paroi interne de l'enceinte 2 par tous moyens appropriés, et notamment par une série de vis (dont une seule vis 34 est visible à la figure 3, pour des raisons de simplifications), capables d'assurer et maintenir un contact intime entre la paroi interne de l'enceinte et la face externe de la pièce massive toroïdale 22a constituant le correcteur thermique précité, qui peut ainsi bénéficier du conditionnement thermique à circulation d'huile de l'enceinte 2.

La variante de réalisation massive du correcteur thermique que l'on vient de décrire est particulièrement avantageuse lorsque les températures de fonctionnement sont particulièrement élevées pour éviter la sublimation du revêtement réfléchissant de la face interne du correcteur thermique ou du moins sa détérioration.

Il va de soi que le contour (ou profil) de la face interne réfléchissante du correcteur thermique est calculée, en général, pour s'adapter au contour (ou profil) de la pièce à traiter et que donc la génératrice de cette face interne est a priori quelconque, bien qu'en pratique les cas plus courants soient représentés par les configurations à symétrie cylindrique ou parallélépipédique.

L'introduction dans la chambre de traitement 4 d'au moins un gaz destiné à créer à l'intérieur de celle-ci une atmosphère contrôlée, permettant d'obtenir des conditions particulières de traitement thermique de la pièce 1, est rendue possible à l'aide d'une gorge toroïdale 35 qui est ménagée à la périphérie du correcteur thermique massif 22a et qui communique avec la chambre de traitement 4 par l'intermédiaire d'une pluralité d'orifices distributeurs radiaux 36.

Les considérations développées en rapport avec la figure 2 et concernant la hauteur et le diamètre interne du correcteur thermique mince 2 restent valables également dans le cas du correcteur thermique massif 2a.

La figure 3 montre également une variante de réalisation des moyens d'accès à la chambre de traitement thermique 4, à savoir du fond 3a de l'enceinte 2, qui a le double avantage de permettre une augmentation des cadences de fonctionnement, grâce à la coopération avec des moyens d'ouverture et de fermeture rapides, ainsi que le réglage précis de la puissance thermique, grâce à l'utilisation d'une sonde pyrométrique, ces deux conditions étant décrites en détail ci-après.

D'abord, on peut remarquer à la figure 3 que l'appareil selon l'invention coopère avec une presse dont le sommier de presse 37 (ou plateau fixe) est fixé rigidement à l'enceinte 2 par l'intermédiaire de colonnettes verticales, parmi lesquelles seulement la colonnette 39 est visible sur le dessin, tandis que le plateau de presse 38 (ou plateau mobile) supporte le fond 3a de l'enceinte 2.

La solidarisation entre le plateau de presse 38 et le fond 3a autorise l'exécution rapide des opérations de fermeture et ouverture de ce fond, ce qui est avantageux, par rapport aux moyens de fixation détachable décrits en relation avec la figure 1, lorsque les cadences de fonctionnement sont relativement importantes.

Dans ce cas l'étanchéité à l'interface enceinte/fond est assurée par la coopération des moyens suivants :
   – une nervure annulaire 40, faisant saillie notamment de la face inférieure de l'enceinte 2, à laquelle se transmet l'effort de pressage par l'intermédiaire des colonnettes 39 précitées et du corps de l'enceinte 2,
   – une cavité toroïdale 41 disposée à l'extérieur de la nervure 40 et destinée à la récupération des fuites de gaz éventuelles, par l'intermédiaire d'un circuit en dépression (non représenté) avec lequel est en communication la cavité 41 (cette cavité est obtenue en ménageant deux gorges toroïdales, opposées l'une à l'autre, dans les faces appliquées l'une contre l'autre de l'enceinte 2 et du fond 3a),
   – un joint 42, en graphite expansé, disposé à l'extérieur de la cavité toroïdale 41 et logé notamment dans une gorge périphérique ménagée dans le fond 3a.

Avant de décrire les moyens de réglage de la puissance utilisée dans le traitement thermique, il convient de décrire la variante de réalisation de la source thermique lumineuse utilisée dans l'appareil de la figure 3.

Cette source est réalisée sous la forme d'une boîte à lumière 16a ayant une structure modulaire qui permet d'adapter la puissance installée à la puissance requise par le traitement de la pièce mince 1.

La boîte à lumière 16a comporte une pluralité de modules creux superposables 43, chaque module ayant une section polygonale et étant délimité par des parois latérales métalliques verticales 44.

A proximité et parallèlement à chaque paroi sont disposées, à l'intérieur du module, des rangées horizontales de lampes parallèles "tungstène-halogène" 17 qui traversent les deux parois adjacentes du module de manière que les culots 45 des lampes se trouvent à l'extérieur du module, ce qui permet de les refroidir efficacement par ventilation forcée.

On peut remarquer également que deux lampes consécutives de chaque rangée de lampes 17 sont séparées d'un pas (ou distance) suffisant pour permettre le passage entre elles d'une lampe appartenant à chacune des deux rangées de lampes adjacentes.

Bien entendu, la largeur de chaque paroi du module est définie par la dimension utile (ou active) de chaque lampe, à savoir par la longueur de son filament de tungstène.

Le module qu'on vient de décrire, lorsqu'il est utilisé seul (ou le module supérieur d'une pile de modules du même type superposés l'un à l'autre) coopère avec un élément métallique de fermeture 46 constituant le couvercle ou plafond de la boîte à lumière 16a ainsi réalisée.

Le cas échéant, également le plafond 46 peut coopérer avec une rangée de lampes "tungstène-halogène", si la valeur de puissance à installer l'exige.

Dans chaque cas, les faces internes des parois latérales 44 et du plafond 46 de chaque module 43 sont dorées, à savoir qu'elles sont rendues réfléchissantes dans tout le spectre d'émission des lampes, comme déjà précisé plus haut, et chaque module est refroidi par circulation d'eau (non représentée).

Etant donné que la symétrie de l'enceinte est circulaire, alors que la boîte à lumière est à section polygonale (de préférence ayant un nombre pair de côtés), une bride de raccordement 47 – elle aussi réfléchissante sur toute sa surface interne – est prévue pour permettre le passage de la section polygonale du module inférieur de la boîte à lumière 16a à la section circulaire de l'enceinte 2.

La boîte à lumière 16a est solidarisée du sommier de presse 37 par l'intermédiaire d'une structure portante 48 qui est bâtie autour des colonnettes 39 précitées.

Revenant aux moyens de réglage de la puissance installée, et notamment de la puissance de chaque module 43 de la boîte à lumière 16a, il y a lieu de préciser qu'ils sont constitués par des dispositifs (connus en soi et non représentés) de commutation des lampes de chaque module ou de variation de la tension d'alimentation des lampes, lesquels dispositifs de réglage sont commandés par une sonde pyrométrique (connue des techniciens en la matière et non représentée dans le dessin de la figure 3) qui est activée par le rayonnement provenant de la face inférieure de la plaquette 1.

Ce rayonnement arrive jusqu'à la sonde, située à l'extérieur de l'appareil, en suivant le parcours défini par :

    – un conduit axial 49 ménagé dans le fond 3a de l'enceinte 2 et communiquant avec la chambre de traitement 4,

    – un hublot 50 de visée de la face inférieure de la plaquette 1, disposé à la partie inférieure et à la suite du conduit 49 en alignement axial avec ce dernier,

    – un prisme 51 logé dans une pièce rapportée 52, logée à son tour dans le fond 3a de l'enceinte 2, le rayonnement étant dirigé du hublot 50 vers ce prisme par un deuxième conduit axial 53 ménagé dans la pièce rapportée 52,

    – une fibre optique 54 disposée à 90° par rapport à l'axe de la chambre de traitement thermique 4, le rayonnement étant dirigé du prisme 51 vers la fibre optique 54 par l'intermédiaire d'un conduit transversal 55 perpendiculaire au conduit 53 et ménagé, comme ce dernier, dans la pièce rapportée 52.

En ce qui concerne les plots de support et de centrage de la pièce à traiter 1, il y a lieu de remarquer qu'à la figure 3 on a présenté une variante 15* (un seul plot y a été représenté pour des raisons de simplification) qui comporte en plus, par rapport aux plots 15a, 15b, ... de la figure 1, une butée latérale de centrage 56 faisant saillie vers le haut à partir de la paroi latérale externe de chaque plot.

En outre, on peut aussi remarquer que les plots 15* sont encastrés dans le fond 3a, ce qui permet la descente et la montée automatiques de la pièce 1, qui suit ainsi les mouvements du plateau de presse 38.

Bien qu'il soit superflu de le souligner, il va de soi qu'il est avantageux de pourvoir également au conditionnement thermique du fond 3a de l'enceinte 2 de la figure 3 effectué de manière analogue à l'enceinte 2 elle-même (dans les figures 1 et 3).

A cet effet, un fluide thermostaté, constitué par exemple par de l'huile issue d'un bain thermostaté, circule autour d'une chemise de conditionnement 57 ménagée dans le fond 3a et reliée à un circuit de conditionnement.

Ainsi que cela ressort de ce qui précède, l'invention ne se limite nullement à ceux de ses modes de réalisation et d'application qui viennent d'être décrits de façon plus explicite ; elle en embrasse, au contraire, toutes les variantes qui peuvent venir à l'esprit du technicien en la matière : par exemple, bien que le traitement visant à obtenir des surfaces réfléchissantes ait été indiqué comme comportant des opérations de polissage et de dépôt or, il va de soi que ce traitement n'est pas limitatif et que, en général, on vise tout traitement de surface capable de rendre les surfaces concernées réfléchissantes dans tout le spectre d'émission des lampes utilisées.

En outre, bien qu'on ait décrit une source thermique lumineuse disposée d'un seul côté de la pièce (wafer) à traiter, rien ne s'oppose à l'utilisation de deux sources du même type disposées de part et d'autre de cette pièce : ceci est particulièrement aisé avec le mode de réalisation illustré à la figure 3 où, grâce à la conception modulaire de la source 16a, il suffit de modifier l'enceinte 2 de manière que celle-ci puisse loger deux hublots 5 disposés de part et d'autre de la pièce 1 (en adoptant les mêmes dispositions illustrées pour le hublot unique qui y est représenté) et de solidariser à la partie inférieure de l'enceinte ainsi modifiée une autre boîte à lumière 16a (dont le couvercle devrait être nécessairement perforé pour permettre la visée de la face inférieure de la pièce 1 et donc d'effectuer la mesure de température à l'aide d'une sonde pyrométrique).

Egalement immédiates, et de toutes façons à la portée des techniciens en la matière, sont les modifications des moyens 3a pour les adapter à l'enceinte 2 modifiée dans le sens susdit.

Les avantages liés à la possibilité de doubler la source thermique lumineuse, selon les termes précités, consistent en ce que, par ce moyen, il est non seulement possible d'effectuer simultanément le traitement des deux faces de la pièce 1, mais aussi d'augmenter la puissance thermique installée et la vitesse de montée en température de cette pièce.

## Revendications

1. Appareil pour le traitement thermique d'une pièce mince (1), telle qu'une plaquette circulaire (wafer) de silicium, comprenant :

    – une source thermique lumineuse (16, 16a) comportant des lampes linéaires (17) de très forte puissance unitaire, telles que des lampes "tungstène-halogène" ;

    – une enceinte (2) à section circulaire dont l'axe de symétrie géométrique (21) coïncide avec l'axe de symétrie optique (21) de ladite source thermique lumineuse, cette enceinte (2) délimitant une chambre (4) étanche contenant la pièce à traiter et permettant de créer autour de celle-ci des conditions particulières de traitement thermique, notamment sous pression ou sous vide ou dans une atmosphère d'un gaz approprié ;

– et un moyen de compensation des pertes thermiques de la pièce à traiter (1) permettant de maintenir sensiblement uniforme sa température,

– caractérisé en ce que le moyen de compensation des pertes thermiques de la pièce à traiter est constitué par un réflecteur annulaire (22, 22a) placé dans la chambre (4) et entourant étroitement la pièce à traiter (1), le diamètre interne et la hauteur de ce réflecteur annulaire étant choisis de telle sorte qu'il n'y ait pas occultation partielle de la source lumineuse (16, 16a).

2. Appareil selon la revendication 1, caractérisé en ce que le réflecteur de compensation thermique est constitué par une pièce toroïdale massive (22a), dont la face interne est réfléchissante dans tout le spectre d'émission des lampes (17) et qui est fixée à la paroi interne de l'enceinte (2) par tous moyens appropriés, notamment par vissage, de manière à assurer un contact intime entre la paroi interne de l'enceinte (2) et la face externe de la pièce toroïdale massive (22a).

3. Appareil selon la revendication 2, caractérisé en ce qu'une gorge toroïdale (35) coaxiale est ménagée à la périphérie de la paroi de la pièce toroïdale massive (22a) et communique avec des orifices distributeurs radiaux (36) permettant l'introduction dans la chambre de traitement (4) d'au moins un gaz approprié.

4. Appareil selon la revendication 1, caractérisé en ce que ledit réflecteur de compensation thermique (22) est constitué par un clinquant (23) dont la face interne (24) est réfléchissante dans tout le spectre d'émission des lampes (17) et dont la configuration annulaire est obtenue par roulage et est maintenue par serrage à l'aide d'une bague (25) inoxydable d'épaisseur appropriée.

5. Appareil selon l'une quelconque des revendications 2 à 4, caractérisé en ce que la pièce à traiter (1) est maintenue par des moyens de support et de centrage par rapport au réflecteur de compensation thermique.

6. Appareil selon la revendication 5, caractérisé en ce que les moyens de support et de centrage sont constitués par trois plots (15a, 15b... ; 15*, ...) à calotte sphérique encastrés dans le fond (3, 3a) de l'enceinte (2) et permettant de réduire au minimum le contact avec la pièce à traiter (1) et donc d'influencer le moins possible les échanges thermiques de celle-ci, chaque plot coopérant avec un moyen de butée latérale de centrage (56) faisant saillie vers le haut à partir de la paroi latérale externe du plot correspondant.

7. Appareil selon la revendication 1, caractérisé en ce que la chambre de traitement (4) comporte un moyen d'accès et est délimitée par la paroi latérale et le fond (3, 3a) de l'enceinte (2) ainsi que par un hublot (5) cylindrique, réalisé en silice et entièrement poli, ayant un diamètre et une épaisseur appropriés et interposé entre la source (16, 16a) et la pièce à traiter (1) et dont l'axe coïncide avec l'axe optique de la source et l'axe de l'enceinte (2), et en ce que la paroi latérale de l'enceinte (2) comporte un siège (6) sur lequel prend appui le hublot (5), ce dernier étant maintenu en position par l'intermédiaire d'une bride de fixation (7) qui serre le hublot contre son siège à l'aide d'une pluralité de vis (12) réalisées en un matériau ayant un coefficient de dilatation thermique pratiquement négligeable, entre ledit siège (6) et le hublot (5) et ce dernier et la bride de fixation (7) étant disposés, respectivement, des joints d'étanchéité (9, 10) en matériau approprié, tel que du graphite expansé.

8. Appareil selon la revendication 7, caractérisé en ce que ledit moyen d'accès à la chambre de traitement (4) est constitué par le fond (3a) de ladite enceinte (2), lequel fond coopère avec des moyens d'ouverture et de fermeture rapides, autorisant ainsi une augmentation des cadences de fonctionnement et constitués par le plateau mobile (38) d'une presse duquel est solidaire le fond de l'enceinte, le plateau fixe ou sommier (37) de la presse étant solidarisé avec la partie supérieure de l'enceinte (2) par l'intermédiaire de colonnettes rigides (39), et en ce que l'étanchéité à l'interface enceinte (2)/fond (3a) est assurée par la coopération des moyens suivants :

– une nervure annulaire (40) faisant saillie de l'une ou l'autre des surfaces de séparation enceinte (2)/fond (3a) et à laquelle se transmet, par l'intermédiaire desdites colonettes (39), l'effort de pressage,

– une cavité toroïdale (41) disposée à l'extérieur de ladite nervure annulaire (40) et destinée à la récupération des fuites de gaz éventuelles, à cet effet la cavité (41) étant reliée à un circuit de récupération en dépression,

– un joint (42) en un matériau approprié, tel que du graphite expansé, disposé à l'extérieur de cette cavité toroïdale (41).

9. Appareil selon la revendication 7, caractérisé en ce que ledit moyen d'accès à la chambre de traitement (4) est constitué par le fond (3) de ladite enceinte (2), lequel fond est amovible et fixé à la base de l'enceinte à l'aide de moyens de fixation détachable.

10. Appareil selon la revendication 9, caractérisé en ce que les moyens de fixation détachable du fond (3) sont constitués par une pluralité de vis (11) réalisées en un matériau ayant un coefficient de dilatation thermique pratiquement négligeable, un joint d'étanchéité (8) en un matériau approprié, tel que du graphite expansé, étant disposé entre ledit fond et ladite base de l'enceinte.

11. Appareil selon la revendication 1, caractérisé en ce que ladite source thermique lumineuse est réalisée sous la forme d'une boîte à lumière (16a) ayant une structure modulaire qui permet d'adapter la puissance installée à la puissance requise par le traitement de la pièce (1) et comportant :

– au moins un module creux (43) à section polygonale, délimité par des parois métalliques (44) latérales verticales et contenant à proximité de chaque paroi (44) des rangées horizontales parallèles de lampes linéaires (17) "tungstène-halogène" qui traversent deux parois adjacentes du module, de manière que les culots (45) des lampes (17) se trouvent disposés à l'extérieur du module (43) et que leur refroidissement, notamment par ventilation forcée, soit efficace, deux lampes (17) consécutives de chaque rangée étant séparées d'un pas approprié permettant le passage entre elles d'une lampe appartenant à chacune des deux rangées de lampes adjacentes, la largeur de chaque paroi (44) étant définie par la dimension utile de chaque lampe (17), à savoir par la longueur du filament de tungstène,

– un élément métallique de fermeture (46) de l'ouverture supérieure dudit module (43) ou du module (43) situé le plus haut parmi une pluralité de modules du même type superposés l'un à l'autre et dont le nombre est fonction de la puissance requise par le traitement thermique, lequel élément (46) constitue le couvercle ou le plafond de la boîte à lumière (16a), les faces internes des parois latérales (44) et du plafond (46) de la boîte à lumière (16a) étant réfléchissantes dans tout le spectre d'émission des lampes (17) et chaque module (43) étant refroidi par circulation d'un fluide approprié, notamment d'eau.

12. Appareil selon la revendication 11, caractérisé en ce que également le plafond (46) de la boîte à lumière (16a) coopère avec une rangée de lampes linéaires "tungstène-halogène" disposées horizontalement et parallèlement audit plafond.

13. Appareil selon la revendication 11, caractérisé en ce qu'une bride de raccordement (47) relie le module inférieur (43) de la boîte à lumière (16a) à l'enceinte (2), permettant ainsi le passage de la section polygonale du module (43) à la section circulaire de l'enceinte (2), la paroi interne de la bride de raccordement (47) étant elle aussi réfléchissante dans tout le spectre d'émission des lampes (17).

14. Appareil selon la revendication 1, caractérisé en ce que ladite source thermique lumineuse (16) comporte plusieurs rangées parallèles (I, II) de lampes "tungstène-halogène" (17), deux lampes consécutives de chaque rangée étant séparées d'un pas approprié et les rangées étant décalées d'un demi-pas et étant disposées à une distance appropriée l'une par rapport à l'autre, lesquelles rangées de lampes sont logées dans un capotage (18) en tôle, auquel est fixée ladite enceinte (2) par tous moyens appropriés (32) et qui est refroidi par des ventilateurs (19), et en ce que la source lumineuse (16) coopère avec un réflecteur (26), réfléchissant dans tout le spectre d'émission des lampes (17), qui est logé dans ledit capotage (18) et qui est destiné à améliorer son rendement lumineux et est disposé au-dessus et autour de cette source, de manière que son axe coïncide avec l'axe optique de cette dernière, ce réflecteur (26) étant refroidi par circulation d'un fluide approprié, notamment d'eau.

15. Appareil selon la revendication 11 caractérisé en ce qu'il comporte des moyens de réglage de la puissance de chaque module, notamment constitués par des dispositifs de commutation et/ou des dispositifs de variation de la tension d'alimentation des lampes, lesquels moyens de réglage sont commandés par une sonde pyrométrique activée par le rayonnement provenant de la face intérieure de la pièce à traiter (1), et ce sous le contrôle d'un ordinateur programmé pour compenser toute variation indésirée de la puissance installée ainsi que pour adapter le traitement thermique à un cycle bien déterminé.

16. Appareil selon la revendication 15, caractérisé en ce que le rayonnement activant la sonde pyrométrique se propage à travers :

– un premier conduit axial (49) ménagé dans le fond (3a) de l'enceinte (2) et s'ouvrant supérieurement dans la chambre de traitement,

– un hublot (50) de visée de la face intérieure de la pièce (1), disposé à la suite et à la partie inférieure de ce conduit axial (49), dont l'axe est aligné avec celui du hublot de visée (50),

– un prisme (51) logé dans une pièce rapportée (52), logée à son tour dans le fond (3a) de l'enceinte (2), le rayonnement étant dirigé du hublot de visée (50) vers ce prisme (51) par un deuxième conduit axial (53) ménagé dans ladite pièce rapportée (52),

– une fibre optique (54) disposée à 90° par rapport à l'axe de la chambre de traitement thermique (4), le rayonnement étant dirigé du prisme (51) vers la fibre optique (54) par l'intermédiaire d'un conduit transversal (55) perpendiculaire audit deuxième conduit axial (53) et ménagé, comme ce dernier, dans ladite pièce rapportée (52).

17. Appareil selon la revendication 7, caractérisé en ce qu'il comporte des moyens de conditionnement thermique destinés à limiter la montée en température du hublot (5) et constitués par un circuit (29) traversé par un fluide thermostaté approprié, tel que de l'huile issue d'un bain thermostaté, et comportant des chemises de conditionnement ménagées dans l'enceinte, à la périphérie du hublot (5) et autour des vis de serrage (12) de ladite bride de fixation (7).

18. Appareil selon la revendication 16, caractérisé en ce que le fond (3a) de l'enceinte (2) comporte des moyens de conditionnement thermique du type utilisé pour l'enceinte (2), à savoir constitués par un circuit traversé par un fluide thermostaté approprié tel que de l'huile issue d'un bain thermostaté, et comportant une chemise de conditionnement (57) ménagée dans le fond (3a) de l'enceinte (2).

## Ansprüche

1. Einrichtung für die thermische Behandlung eines dünnen Teiles (1), wie eines kreisförmigen Plättchens (wafer) aus Silizium, die aufweist :
   - eine leuchtende thermische Quelle (16, 16a), die aus Linienlampen (17) mit sehr großer Einheitsleistung, wie "Halogen"-Lampen besteht,
   - eine Einfassung (2) mit kreisförmigem Querschnitt, deren geometrische Symmetrieachse (21) mit der optischen Symmetrieachse (21) der leuchtenden thermischen Quelle zusammenfällt, wobei diese Einfassung (2) eine dichte Kammer (4) abgrenzt, welche den zu behandelnden Teil enthält und es ermöglicht, um dieses herum spezielle Bedingungen für eine thermische Behandlung, namentlich unter Druck oder unter Vakuum oder in einer Atmosphäre aus einem geeigneten Gas herzustellen,
   - und ein Kompensationsmittel für die thermischen Verluste des zu behandelnden Teiles (1), das es ermöglicht, seine Temperatur im wesentlichen gleichmäßig zu halten,
   - dadurch gekennzeichnet, daß das Kompensationsmittel für die thermischen Verluste des zu behandelnden Teiles aus einem ringförmigen Reflektor (22, 22a) besteht, welcher in der Kammer (4) angebracht ist und den zu behandelnden Teil (1) eng umgibt, wobei der Innendurchmesser und die Höhe dieses ringförmigen Reflektors so gewählt sind, daß es keine teilweise Verdeckung der Lichtquelle (16, 16a) gibt.

2. Einrichtung nach Anspruch 1, dadurch gekennzeichnet, daß der Reflektor für eine thermische Kompensation aus einem massiven toroiden Teil (22a) besteht, dessen Innenfläche in dem ganzen Emissionsspektrum der Lampen (17) reflektierend ist und der an der Innenwand der Einfassung (2) durch Jedes geeignete Mittel, namentlich durch eine Schraubverbindung befestigt ist, um eine innige Berührung zwischen der Innenwand der Einfassung (2) und der Außenfläche des massiven toroiden Teiles (22a) zu gewährleisten.

3. Einrichtung nach Anspruch 2, dadurch gekennzeichnet, daß eine koaxiale toroide Kehle (35) an dem Umfang der Wand des massiven toroiden Teiles (22a) angeordnet ist und mit radialen Verteileröffnungen (36) kommuniziert, wodurch die Einleitung zumindest eines geeigneten Gases in die Behandlungskammer (4) ermöglicht ist.

4. Einrichtung nach Anspruch 1, dadurch gekennzeichnet, daß der Reflektor für eine thermische Kompensation (22) aus einer Metallfolie (23) besteht, deren Innenfläche (24) in dem ganzen Emissionsspektrum der Lampen (17) reflektierend ist und deren ringförmige Form durch Rollen erhalten und durch Einspannen mit Hilfe eines nichtoxidierbaren Ringes (25) geeigneter Dicke aufrechterhalten wird.

5. Einrichtung nach irgend einem der Ansprüche 2 bis 4, dadurch gekennzeichnet, daß der zu behandelnde Teil (1) durch Mittel zum Tragen und zum Zentrieren bezüglich des Reflektors für eine thermische Kompensation gehalten ist.

6. Einrichtung nach Anspruch 5, dadurch gekennzeichnet, daß die Mittel zum Tragen und zum Zentrieren aus drei Kontakten (15a, 15b, ..., 15*) mit einer Kugelkappe bestehen, die in dem Boden (3, 3a) der Einfassung (2) eingefügt sind und es ermöglichen, die Berührung mit dem zu behandelnden Teil (1) auf ein Minimum zu verringern und folglich seine thermischen Änderungen so wenig wie möglich zu beeinflussen, wobei jeder Kontakt mit einem Mittel für einen seitlichen Anschlag zum Zentrieren (56) zusammenwirkt, der aufwärts von der äußeren seitlichen Wand des entsprechenden Kontaktes einen Vorsprung bildet.

7. Einrichtung nach Anspruch 1, dadurch gekennzeichnet, daß die Behandlungskammer (4) ein Zugriffsmittel aufweist und durch die seitliche Wand und den Boden (3, 3a) der Einfassung (2) sowie durch ein zylindrisches Fenster (5) abgegrenzt ist, das aus Silizium hergestellt und ganz poliert ist, wobei dieses einen geeigneten Durchmesser und eine geeignete Dicke aufweist und zwischen der Quelle (16, 16a) und dem zu behandelnden Teil (1) eingefügt ist und dessen Achse mit der optischen Achse der Quelle und der Achse der Einfassung (2) zusammenfällt, und daß die seitliche Wand der Einfassung (2) einen Sitz (6) aufweist, auf den sich das Fenster (5) stützt, wobei dieses letztere über einen Befestigungsflansch (7) in Lage gehalten ist, welcher das Fenster gegen seinen Sitz mit Hilfe einer Mehrzahl von Schrauben (12) klemmt, die aus einem Material mit einem praktisch vernachlässigbaren thermischen Ausdehnungskoeffizienten hergestellt sind, wobei zwischen dem Sitz (6) und dem fenster (5) und diesem letzteren und dem Befestigungsflansch (7) jeweils Dichtungen (9, 10) aus geeignetem Material, wie expandiertem Graphit angeordnet sind.

8. Einrichtung nach Anspruch 7, dadurch gekennzeichnet, daß das Zugriffsmittel für die Behandlungskammer (4) aus dem Boden (3a) der Einfassung (2) besteht, wobei dieser Boden mit Mitteln zum schnellen Öffnen und Schließen zusammenwirkt, wodurch eine Erhöhung der zeitlichen Folgen eines Ablaufes ermöglicht ist und die aus der beweglichen Platte (38) einer Presse bestehen, mit welcher der Boden der Einfassung verbunden ist, wobei die feste Platte oder der Balken (37) der Presse mit dem oberen Teil der Einfassung (2) über starre kleine Säulen (39) verbunden ist, und daß die Dichtung an der Übergangsfläche Einfassung (2)/Boden (3a) durch das Zusammenwirken der folgenden Mittel gewährleistet ist :

– eine ringförmige Rippe (40), die von einer oder der anderen der Oberflächen für eine Trennung Einfassung (2)/Boden (3a) einen Vorsprung bildet und an die sich über die kleinen Säulen (39) die Druckkraft überträgt,

– ein toroider Hohlraum (41), der außerhalb der ringförmigen Rippe (40) angeordnet ist und zur Widergewinnung der etwaigen Gasausströmungen bestimmt ist, wobei der Hohlraum (41) zu diesem Zweck mit einem Kreis zur Wiedergewinnung unter Unterdruck verbunden ist,

– eine Dichtung (42) aus einem geeigneten Material, wie expandiertem Graphit, die außerhalb dieses toroiden Hohlraumes (41) angeordnet ist.

9. Einrichtung nach Anspruch 7, dadurch gekennzeichnet, daß das Zugriffsmittel für die Behandlungskammer (4) aus dem Boden (3) der Einfassung (2) besteht, wobei dieser Boden abnehmbar ist und an der Basis der Einfassung mit Hilfe von Mitteln für eine lösbare Befestigung befestigt ist.

10. Einrichtung nach Anspruch 9, dadurch gekennzeichnet, daß die Mittel für eine lösbare Befestigung des Bodens (3) aus einer Mehrzahl von Schrauben (11) bestehen, die aus einem Material mit einem praktisch vernachlässigbaren thermischen Ausdehnungskoeffizienten hergestellt sind, wobei eine Dichtung (8) aus einem geeignetem Material, wie expandiertem Graphit, zwischen dem Boden und der Basis der Einfassung angeordnet ist.

11. Einrichtung nach Anspruch 1, dadurch gekennzeichnet, daß die leuchtende thermische Quelle in Form eines Leuchtkastens (16a) mit modularem Aufbau hergestellt ist, der es ermöglicht, die installierte Leitung der durch die Behandlung des Teiles (1) erforderlichen Leistung anzupassen und der aufweist :

– zumindest einen hohlen Modul (43) mit polygonalem Querschnitt, der durch vertikale, seitliche, metallische Wände (44) abgegrenzt ist und in der Nähe jeder Wand (44) parallele horizontale Reihen von "Halogen"-Linienlampen (17) enthält, die zwei benachbarte Wände des Moduls so durchqueren, daß die Sockel (45) der Lampen (17) außerhalb des Moduls (43) angeordnet zu finden sind und daß ihre Kühlung, namentlich durch Zwangslüftung wirkungsvoll ist, wobei zwei aufeinanderfolgende Lampen (17) jeder Reihe um einen geeigneten Abstand getrennt sind, der zwischen ihnen die Durchführung einer Lampe ermöglicht, die jeder der zwei Reihen benachbarter Lampen angehört, wobei die Breite jeder Wand (44) durch die nutzbare Abmessung jeder Lampe (17), nämlich durch die Länge des Wolframfadens definiert ist,

– ein metallisches Element zum Schließen (46) der oberen Öffnung des Moduls (43) oder des Moduls (43), der am höchsten aus einer Mehrzahl von Modulen desselben Typs gelegen ist, die übereinandergelegt sind und deren Anzahl von der durch die thermische Behandlung erforderlichen Leistung abhängt, wobei das Element (46) die Abdeckung oder die Decke des Leuchtkastens (16a) bildet, die Innenflächen der seitlichen Wände (44) und der Decke (46) des Leuchtkastens (16a) in dem ganzen Emissionsspektrum der Lampen (17) reflektierend sind und jeder Modul (43) durch Zirkulation eines geeigneten Fluides, namentlich von Wasser, gekühlt ist.

12. Einrichtung nach Anspruch 11, dadurch gekennzeichnet, daß die Decke (46) des Leuchtkastens (16a) mit einer Reihe von "Halogen"-Linienlampen ebenfalls zusammenwirkt, die an der Decke horizontal und parallel angeordnet sind.

13. Einrichtung nach Anspruch 11, dadurch gekennzeichnet, daß ein Anschlußflansch (47) den unteren Modul (43) des Leuchtkestens (16a) mit der Einfassung (2) verbindet, wodurch die Durchführung des polygonalen Querschnitts des Moduls (43) an dem kreisförmigen Querschnitt der Einfassung (2) ermöglicht ist, wobei auch die Innenwand des Anschlußflansches (47) in dem ganzen Emissionsspektrum der Lampen (17) reflektierend ist.

14. Einrichtung nach Anspruch 1, dadurch gekennzeichnet, daß die leuchtende thermische Quelle (16) mehrere parallele Reihen (I, II) von "Halogen"-Lampen (17) aufweist, wobei zwei aufeinanderfolgende Lampen jeder Reihe durch einen geeigneten Abstand getrennt sind und die Reihen um einen halben Abstand verschoben und aufeinanderbezogen auf eine geeignete Entfernung angeordnet sind, wobei die Reihen von Lampen in einer Verkleidung (18) aus Blech aufgenommen sind, an welcher die Einfassung (2) durch jedes geeignete Mittel (32) befestigt ist und die durch Ventilatoren (19) gekühlt ist, und daß die Lichtquelle (16) mit einem in dem ganzen Emissionsspektrum der Lampen (17) reflektierenden Reflektor (26) zusammenwirkt, der in der Verkleidung (18) aufgenommen ist und der zum Verbessern ihrer Lichtausbeute bestimmt ist und über und um diese Quelle so angeordnet ist, daß seine Achse mit der optischen Achse dieser letzterer zusammenfällt, wobei dieser Reflektor (26) durch Zirkulation eines geeigneten Fluides, namentlich von Wasser, gekühlt ist.

15. Einrichtung nach Anspruch 11, dadurch gekennzeichnet, daß sie Mittel zum Einstellen der Leistung jedes Moduls aufweist, die namentlich aus Schalteinrichtungen und/oder Einrichtungen zum Ändern der Versorgungsspannung der Lampen bestehen, wobei diese Mittel zum Einstellen durch einen Temperaturfühler gesteuert sind, der durch von der Innenfläche des zu behandelnden Teiles (1) herrührenden Strahlung aktiviert ist und zwar unter der der Steuerung eies programmierten Rechners zum Kompensieren jeder ungewünschten Änderung der installierten Leistung sowie zum Anpassen der thermischen Behandlung an einem vorbestimmten Zyklus.

16. Einrichtung nach Anspruch 15, dadurch gekennzeichnet, daß sich die den Temperaturfühler aktivierende Strahlung ausbreitet durch :
- einen ersten axialen Kanal (49), der in dem Boden (3a) der Einfassung (2) angeordnet ist und sich höher in die Behandlungskammer öffnet,
- ein Fenster (50) zum Beobachten der Innenfläche des Teiles (1), der an der Fortsetzung und an dem unteren Teil dieses axialen Kanals (49) angeordnet ist, dessen Achse mit jener des Fensters Zum Beobachten (50) ausgerichtet ist,
- ein Prisma (51), das in einem hinzugefügten Teil (52) aufgenommen ist, der seinerseits in dem Boden (3a) der Einfassung (2) aufgenommen ist, wobei die Strahlung von dem Fenster zum Beobachten (50) gegen dieses Prisma (51) durch einen zweiten axialen Kanal (53) gelenkt ist, der in dem hinzugefügten Teil (52) angeordnet ist,
- eine Lichtleitfaser (54), die um 90° bezüglich der Achse der Kammer für eine thermische Behandlung (4) angeordnet ist, wobei die Strahlung von dem Prisma (51) gegen die Lichtleitfaser (54) über einen transversalen Kanal (55) gelenkt ist, der zu dem zweiten axialen Kanal (53) senkrecht liegt und wie dieser letztere, in dem hinzugefügten Teil (52) angeordnet ist.

17. Einrichtung nach Anspruch 7, dadurch gekennzeichnet, daß sie Mittel zum thermischen Konditionieren aufweist, die zum Begrenzen des Temperaturanstieges des Fensters (5) bestimmt sind und aus einem Kreis (29) bestehen, der durch ein geeignetes, thermostabilisiertes Fluid, wie Öl durchströmt ist, das aus einem thermostabilisiertem Bad stammt und die Konditioniermäntel aufweisen, die in der Einfassung an dem Umfang des Fensters (5) und um die Klemmschrauben (12) des Befestigungsflansches (7) angeordnet sind.

18. Einrichtung nach Anspruch 16, dadurch gekennzeichnet, daß der Boden (3a) der Einfassung (2) Mittel zum thermischen Konditionieren des Typs aufweist, der für die Einfassung (2) verwendet ist, das heißt, solche, die aus einem Kreis bestehen, der durch ein geeignetes thermostabilisiertes Fluid, wie Öl durchströmt ist, das aus einem thermostabilisiertem Bad stammt und einen Konditioniermantel (57) aufweist, der in dem Boden (3a) der Einfassung (2) angeordnet ist.

## Claims

1. Apparatus for heat treating a thin part (1) such as a silicon wafer, the apparatus comprising :
- a light-emitting heat source (16, 16a) including very high unit power linear lamps (17) such as "tungsten-halogen" lamps ;
- a circular section enclosure (2) whose geometrical axis of symmetry (21) coincides with the optical axis of symmetry (21) of said light-emitting heat source, said enclosure (2) delimiting a sealed chamber (4) containing the part to be treated and enabling special heat treatment conditions to be created thereabout, in particular under pressure or under a vacuum or in an atmosphere of an appropriate gas ; and
- means for compensating heat losses from the part to be treated (1) enabling its temperature to be maintained substantially uniform ;
- the apparatus being characterized in that the means for compensating heat losses from the part to be treated are constituted by an annular reflector (22, 22a) placed inside the chamber (4) and closely surrounding the part to be treated (1), the inside diameter and the height of said annular reflector being selected in such a manner that there is no partial screening of the light-emitting source (16, 16a).

2. Apparatus according to claim 1, characterized in that the thermal compensation reflector is constituted by a solid toroidal part (22a) whose inside face is reflective over the entire emission spectrum of the lamps (17) and which is fixed to the inside wall of the enclosure (2) by any appropriate means, in particular by screws, thereby ensuring intimate contact between the inside wall of the enclosure (2) and the outside face of the solid toroidal part (22a).

3. Apparatus according to claim 2, characterized in that a coaxial toroidal groove (35) is formed in the periphery of the wall of the solid toroidal part (22a) and communicates with radial delivery orifices (36) enabling at least one appropriate gas to be inserted into the treatment chamber (4).

4. Apparatus according to claim 1, characterized in that said thermal compensation reflector (22) is constituted by metal foil (22) whose inside face (24) is reflective over the entire emission spectrum of the lamps (17) and whose annular configuration is obtained by rolling, the foil being held by being clamped against a stainless ring (25) of appropriate thickness.

5. Apparatus according to any one of claims 2 to 4, characterized in that the part to be treated is held by means for supporting it and centering it relative to the thermal compensation reflector.

6. Apparatus according to claim 5, characterized in that the support and centering means are constituted by three studs (15a, 15b, ... ; 15*, ...) having hemispherical heads and received in the bottom (3, 3a) of the enclosure (2), thereby minimizing contact with the part to be treated (1) and thus having as little influence as possible on the heat exchanges thereof, each stud co-operating with centering lateral abutment means (56) projecting upwards from the outside wall of the corresponding stud.

7. Apparatus according to claim 1, characterized in that the treatment chamber (4) includes access means and is delimited by a side wall and a bottom (3, 3a) of the enclosure (2) and by a cylindrical window (5) made of silica and fully polished, having appropriate diameter and thickness, and being interposed between the source (16, 16a) and the part to be treated (1) and having its axis coinciding with the optical axis of the source and the axis of the enclosure (2), and in that the side wall of the enclosure (2) includes a seat (6) on which the window bears, said window being held in position by means of a fixing rim (7) which clamps the window against its seat under urging from a plurality of screws (12) made out of a material having a practically negligible coefficient of thermal expansion, sealing rings (9, 10) of suitable material such as expanded graphite being disposed respectively between said seat (6) and the window (5) and between said window and the fixing rim (7).

8. Apparatus according to claim 7, characterized in that said access means to the treatment chamber (4) are constituted by the bottom of said enclosure (2), which bottom co-operates with rapid opening and closing means, thereby enabling operating throughput to be increased, said means being constituted by the moving plate (38) of a press, with the fixed plate or backing member (37) of the press being fixed to the top portion of the enclosure (2) via rigid small columns (39), and in that sealing at the interface between the enclosure (2) and the bottom (3a) is provided by co-operation between the following means :
  – an annular rib (40) projecting from one or other of the separation surfaces between the enclosure (2) and the bottom (3a) to which the pressure force is transmitted via said small columns (39) ;
  – a toroidal cavity (41) disposed outside said annular rib (40) and intended to recover possible gas leaks, with the cavity (41) being connected for this purpose to a recovery circuit at reduced pressure ; and
  – a gasket (42) of suitable material, such as expanded graphite, disposed outside said toroidal cavity (41).

9. Apparatus according to claim 7, characterized in that said means providing access to the treatment chamber (4) is constituted by the bottom (3) of said enclosure (2), which bottom is removable and is fixed to the base of the enclosure by detachable fixing means.

10. Apparatus according to claim 9, characterized in that the detachable fixing means for the bottom (3) are constituted by a plurality of screws (11) made of a material having a practically negligible coefficient of thermal expansion, with a sealing gasket (8) made of suitable material such as expanded graphite being disposed between said bottom and said base of the enclosure.

11. Apparatus according to claim 1, characterized in that said light-emitting heat source is constituted in the form of a light box (16a) having a modular structure suitable for adapting the installed power to the power required by the treatment of the part (1), and comprising :
  – at least one polygonal section hollow module (43) delimited by vertical side metal walls (44) and containing, in the vicinity of each wall (44), parallel horizontal rows of linear "tungsten-halogen" lamps (17) which pass through two successive walls of the module so that the bases (45) of the lamps (17) are disposed outside the module (43) and so that the cooling thereof, in particular by forced ventilation, is effective, two consecutive lamps (17) in each row being separated at an appropriate pitch enabling a lamp from each of two adjacent rows of lamps to pass therebetween, the width of each wall (4) being defined by the active size of each lamp (17), i.e. by the length of its tungsten filament ; and
  – a metal element (46) for closing the top opening of said module (43), or of the highest module (43) of a plurality of modules of the same type superposed on top of one another with the number of modules being the function of the power required by the heat treatment, which element (46) is constituted by the lid or the ceiling of the light box (16a), the inside faces of the side walls (44) and of the ceiling of the light box (16a) being reflective over the entire emission spectrum of the lamps (17), and each module (43) being cooled by a flow of suitable fluid, in particular water.

12. Apparatus according to claim 11, characterized in that the ceiling (46) of the light box (16a) also co-operates with a row of linear " tungsten-halogen " lamps disposed horizontally and parallel to said ceiling.

13. Apparatus according to claim 11, characterized in that a connection flange (47) connects the bottom module (42) of the light box (16a) to the enclosure (2), thereby enabling the polygonal section of the module (43) to change to the circular section of the enclosure (2), the inside wall of the connection flange (47) likewise reflecting over the entire emission spectrum of the lamps (17).

14. Apparatus according to claim 1, characterized in that said light-emitting heat source (16) includes a plurality of parallel rows (I, II) of "tungsten-halogen" lamps (17), two consecutive lamps in each row being separated at a suitable pitch and the rows being offset from one another by a half pitch and being disposed at a suitable distance relative to one another, which rows of lamps are housed in a sheet metal cowling (18) which is fixed to said enclosure (2) by any appropriate means (22) and which is cooled by fans (19), and in that the light-emitting source (16) co-operates with a reflector (26) which reflects over the entire emission spectrum of the lamp (17) and which is received in said cowling (18) and which is intended to improve the light yield thereof and is disposed above and around said source in such a manner that its axis coincides with the optical axis thereof, said reflector (26) being cooled by a flow of a suitable fluid, in particular water.

15. Apparatus according to claim 11, characterized in that it includes means for adjusting the power of each module, which means are constituted, in particular, by switching devices and/or by devices for varying the voltage fed to the lamps, which adjustment means are controlled by a pyrometer sensor activated by the radiation from the inside face of the part to be treated (1), under the overall control of a computer which is programmed to compensate for any undesired variation in the installed power and also to adapt the heat treatment to a well-determined cycle.

16. Apparatus according to claim 15, characterized in that the radiation activating the pyrometer sensor propagates through :

   – a first axial duct (49) provided through the bottom (3a) of the enclosure (2) and opening out at its top end into the treatment chamber ;

   – an aiming window (50) in the bottom face of the part (1) disposed after and at the bottom end of said axial duct (49) with the axis of the duct being in alignment with the axis of the aiming window (50) ;

   – a prism (51) housed in an add-on part (52) which is in turn housed in the bottom (3a) of the enclosure (2), radiation being directed from the aiming window (50) to the prism (51) via a second axial duct (53) provided through said add-on part (52) ; and

   – an optical fiber (54) disposed at 90° relative to the axis of the heat treatment chamber (4), the radiation being directed from the prism (51) to the optical fiber (54) via a transverse duct (55) perpendicular to said second axial duct (53) and provided, like said second axial duct, through said add-on part (52).

17. Apparatus according to claim 7, characterized in that it includes thermal conditioning means for limiting the temperature rise of the window (5) and constituted by a circuit (29) having a suitable thermostatically controlled fluid passing therethrough, such as oil from a thermostatically controlled bath, and including conditioning jackets disposed inside the enclosure at the periphery of the window (5) and around the screws (12) for clamping said fixing flange (7).

18. Apparatus according to claim 16, characterized in that the bottom (3a) of the enclosure (2) includes thermal conditioning means of the type used for the enclosure (2), i.e. constituted by a circuit having a suitable thermostatically controlled fluid passing therethrough, e.g. oil from a thermostatically controlled bath, and including a conditioning jacket (57) provided in the bottom (3a) of the enclosure (2).

FIG.1

FIG.2

EP 0 259 414 B1

# FIG. 3